Europäisches Patentamt

European Patent Office

Office européen des brevets

(19)

(11) Publication number: 0 483 805 A1

# EUROPEAN PATENT APPLICATION

(12)

(21) Application number: 91118527.0

(22) Date of filing: 30.10.91

(51) Int. Cl.⁵: G03B 27/32, G03F 7/00

(30) Priority: 01.11.90 JP 296011/90
18.03.91 JP 52088/91
02.08.91 JP 194280/91

(43) Date of publication of application:
06.05.92 Bulletin 92/19

(84) Designated Contracting States:
DE FR GB

(71) Applicant: SEIKO EPSON CORPORATION
4-1, Nishishinjuku 2-chome
Shinjuku-ku Tokyo-to(JP)
Applicant: SEIKO INSTRUMENTS CO., LTD.
31-1, Kameido 6-chome, Koto-ku
Tokyo(JP)

(72) Inventor: Kobayashi, Atsushi

c/o Seiko Epson Corporation, 3-5, Owa
3-chome
Suwa-shi, Nagano-ken(JP)
Inventor: Asawa, Hirosi
c/o Seiko Epson Corporation, 3-5, Owa
3-chome
Suwa-shi, Nagano-ken(JP)
Inventor: Nomura, Yuhiro
c/o Seiko Epson Corporation, 3-5, Owa
3-chome
Suwa-shi, Nagano-ken(JP)

(74) Representative: Blumbach Weser Bergen
Kramer Zwirner Hoffmann Patentanwälte
Radeckestrasse 43
W-8000 München 60(DE)

(54) Image forming device.

(57) Disclosed is an image forming device that uses a photosensitive member (8) with numerous microcapsules on in its surface, in which are enclosed at least a photosensitive material and a coloring material, and that performs heat developing by heating the image-exposed part of the photosensitive member, after which it transfers the image to a transfer member (11) by pressing the photosensitive member and transfer member together. The heating for heat developing and the heating for pressure transfer are performed by the same heat source (32) and/or at substantially the same temperature.

Fig.2

The present invention relates to copiers, printers and other image forming devices that produce images by using a photosensitive transfer type heat developing material, and more particularly it relates to heat developing and pressure transfer devices for developing the material by means of heat and transferring the image by using pressure, respectively.

A prior art example of an image forming device that uses a photosensitive transfer type heat developing material is disclosed in JP-A-62-147461.

A regular pressure roller is used in examples that perform pressure transfer while heating. In order to apply a uniform, sufficient pressure over the entire image, pressure usually applied by passing the image and a transfer medium through the nip between rigid metal pressure rollers.

JP-A-62-232653 discloses that pressure may be reduced and a more compact device may be achieved if a heating device is added to the pressure transfer device.

However, the above prior art technologies present the following problems.

First, since the heat developing mechanism and the pressure transfer mechanism are configured separately and each is controlled at its own temperature, when the two are in proximity to each other, each is affected by the temperature of the other, thus requiring time until they stabilize, during which image quality suffers. Further, external disturbances can destabilize temperature control, also affecting image quality.

Second, since there are two heating mechanisms, a correspondingly large number of parts is required to independently and accurately control the temperature of both, thus making the device undesiredly large and the circuit for control complicated.

The invention is intended to solve the above problems, and its purpose is to offer a low cost image forming device that is compact and lightweight and can easily and consistently produce high quality images.

This object is achieved with an image forming device as claimed.

Preferred embodiments of the invention are subject matter of the dependent claims.

The photosensitive member used in the image forming device of the invention may be a support member on which microcapsules are applied that contain a photosensitive silver halide, reducing agents, polymer compounds, and coloring materials such as disclosed in JP-A-61-275742, for example.

The temperature for heat developing this type of photosensitive member should be 120°-180°C. In the case of pressure transfer, however, sufficient image quality can basically be achieved at room temperature, but, as already noted, the pressure can be reduced if heating is simultaneously performed. Experiments showed that the pressure could be reduced to from one-half to one-third that at room temperature by heating to 50°-100°C.

In one embodiment of the image forming device of the invention, the same heat source is used for heat developing and pressure transfer in order to achieve the above purpose, and basically it is configured with a suitable temperature difference between heat developing and pressure transfer. However, further researches revealed that a good image could be obtained by further raising the heating temperature for pressure transfer so that the heating temperature for heat developing and that for pressure transfer were nearly the same.

Therefore, one embodiment of the image forming device of the invention performs heat developing and heat transfer at nearly the same temperature.

In the prior art, either there was no heating mechanism for pressure transfer or the heating mechanisms for heat developing and pressure transfer were independent of each other.

It was found that the higher the pressure transfer temperature was raised, the more the pressure could be lowered without sacrificing image quality. This is probably because the coloring materials contained in the microcapsules and the binder holding the microcapsules to the support member could be softened more easily. However, when the temperature is too high, uneven density, image shift and other problems occur in the output image due to the limited heat resistance of the support member, etc., and therefore the temperature cannot be raised too high.

Features of a specific embodiment of the invention include (1) heat developing and pressure transfer are performed using the same rollers and (2) a plastic material is used for the surface of at least one of the rollers employed for pressure transfer and heat developing.

Embodiments of the invention will be described below with reference to the diagrammatical drawings in which:

Fig. 1   is a front cross section of a copier forming an embodiment of the invention;

Fig. 2   is a front cross section showing an embodiment of a heat developing and pressure transfer device employing the same heat source;

Fig. 3   is a front cross section showing another embodiment of a heat developing and pressure transfer device employing the same heat source;

Fig. 4   is a front cross section showing an embodiment of a heat developing and pressure transfer device employing nearly the same heating temperature;

Fig.5     is a front cross section showing another embodiment of a heat developing and pressure transfer device employing nearly the same heating temperature;

Fig. 6     is a cross section showing an embodiment of a pressure roller whose surface is covered with rubber; and

Fig. 7     is a front cross section showing an embodiment in which the surface of both rollers of the pressure transfer device is covered with rubber.

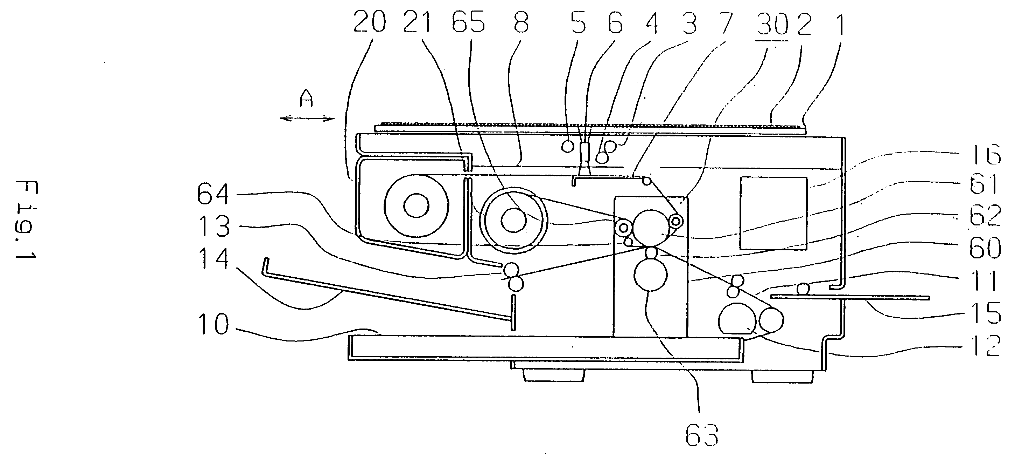

Fig. 1 is a front cross section of an embodiment in which the image forming device of the invention is a copier. First, the operation of the machine is explained. In this embodiment, the same heat source is used for heating both in heat developing and in pressure transfer.

An original 2 is set on an original table 1 which is movable in the direction of arrow A in the Figure. When the light from a red lamp 3, a green lamp 4 and a blue lamp 5, which serve as light sources, irradiates the original 2, the light reflected from the original 2 passes through a lens 6 and forms an image on a photosensitive member 8 that moves on top of an exposure table 7, these elements thus forming a so-called "scan exposure system".

The photosensitive member 8, which is fed out continuously in the form of a sheet from a cartridge 20 where the undeveloped photosensitive member 8 is housed, is exposed on the exposure table 7 to have a latent image formed on it, after which it undergoes heat developing in a heat developer 30. A transfer member 11 stored in a paper supply tray 10 in the form of cut sheets is fed out by a paper supply device 12, is registered with the area of the photosensitive member 8 where the image has been formed, and the two are pressed together in a roller pressure type pressure transfer device 60 to transfer the image to the transfer member 11. The pressure part of the pressure transfer device 60 comprises an upper pressure roller 61, a middle pressure roller 62 and a lower pressure roller 63, and pressure transfer is performed between the upper pressure roller 61 and the middle pressure roller 62.

The transfer member 11 is then separated from the photosensitive member 8 by a separation roller 64, passes through transport roller means 13 and is discharged into a paper tray 14, while the photosensitive member 8 travels past a pinch roller 65, which transports and assists separation, and is wound up on a take up shaft 21.

In the Figure, 15 is a manual paper feed entrance and 16 is a gas filter for removing gas generated in the machine.

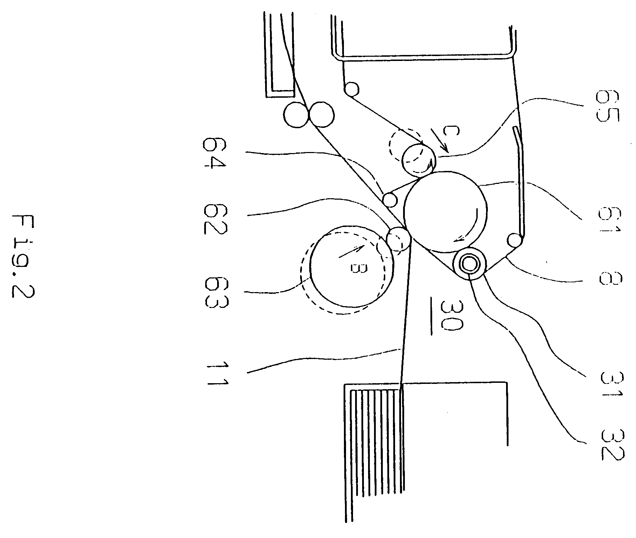

Next, details of the heat developing and pressure transfer device of the embodiment are explained using the front cross section of the heat developing and pressure transfer device in Fig. 2.

First, the photosensitive member 8, on which the latent image has been formed, undergoes heat developing by moving over a heat developing roller 31 which makes up the heat developing device 30. The heat developing roller 31, which is made from a hollow aluminum pipe with a 20 mm outside diameter, houses a halogen lamp with a rated output power of 300 W as the heater 32 and heats the photosensitive member 8 from the back side (side opposite to the latent image).

The transfer member 11 fed from the paper supply device is lined up against the image area on the photosensitive member 8, and the middle pressure roller 62 and the lower pressure roller 63 move in the direction of arrow B and press the photosensitive member 8 and the transfer member 11 between the middle pressure roller 62 and the upper pressure roller 61. While this is happening, the steel upper pressure roller 61 with an outside diameter of 60 mm is in contact with the heat developing roller 31 to be heated by the latter and to heat the photosensitive member 8 and the transfer member 11.

By appropriately changing the diameter or material of the upper pressure roller 61 and/or the heat developing roller 31, the temperature of the upper pressure roller 61 can be changed from near room temperature to nearly the developing temperature without changing the developing temperature, thus facilitating pressure transfer at an appropriate temperature according to the characteristics of the photosensitive member 8 used.

In the case of this embodiment, the heat developing temperature can be appropriately controlled by controlling the power to the heater 32. According to experiments in which a number of heat developing temperatures were tried, the difference between the heat developing temperature and the pressure transfer temperature was generally 20° to 30°C.

After transfer, the photosensitive member 8 is separated from the transfer member 11 by the separation roller 64, passes the pinch roller 65 and is wound up on the take up shaft 21, and while pressure transfer is being performed, the pinch roller 65 moves in the direction of arrow C and is pushed against the upper pressure roller 61 to ensure that the photosensitive member is reliably transported.

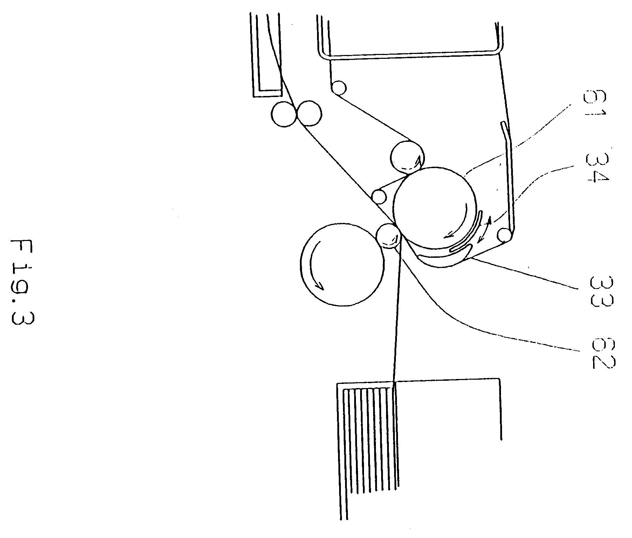

Fig. 3 is a front cross section showing another embodiment in which pressure transfer and heat developing are performed using the same heat source. The photosensitive member 8, on which the latent image has been formed, undergoes heat developing as it passes by a half-moon shaped heater 33. Together with the transfer member it is then sandwiched between the upper pressure roller 61 and the middle pressure roller 62 where pressure transfer is performed. The upper pressure roller 61 is heated by the radiant heat from the heater 33. A heat blocking plate 34 is movable in the direction of arrow D between the heater 33 and the upper pressure roller 61 to change the area on the upper pressure roller 61 irradiated by the heat from the heater 33, whereby the temperature of the upper pressure 61 can be controlled in real time so that a more accurate pressure transfer temperature can be maintained.

Below is a detailed explanation of the heat developing device 30 and the pressure transfer device 60 in an embodiment in which heat developing and pressure transfer are performed at the same temperature, which is a feature of one embodiment of the invention. Also in this embodiment, the same heat source is used for heating in heat developing and pressure transfer.

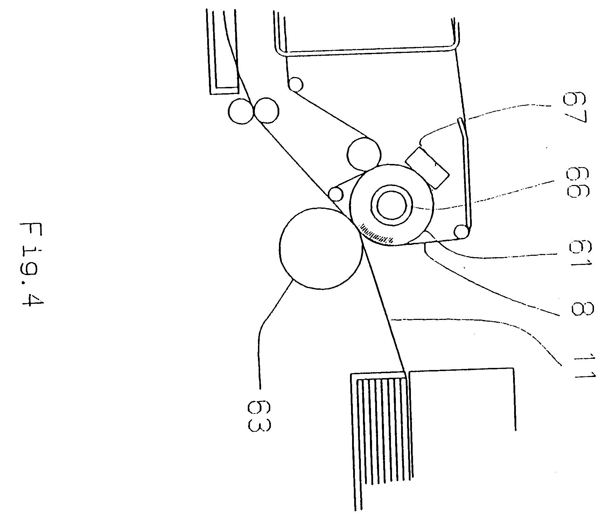

Fig. 4 is a front cross section showing an embodiment of a pressure transfer device that also performs heat developing. A halogen lamp heater 66 is housed inside the hollow upper pressure roller 61, and a temperature sensor 67 is provided on the upper pressure roller 61 to facilitate control at the prescribed temperature. In this embodiment, the mechanism for heat developing is not separate, but rather it is implemented by running the photosensitive member 8 along the upper pressure roller 61, which is one of the rollers by which pressure transfer is performed. The area in which heat developing is performed is the hatched area in the Figure, and heat developing and pressure transfer are processed continuously at nearly the same temperature. Therefore, the heating mechanism is extremely simple, transport of the photosensitive member 8 can be performed reliably and the quality of the output image is consistent.

Experiments with various photosensitive members revealed that the appropriate heating temperature at which heat developing and pressure transfer were performed was 80° to 160°C. Further, a more desirable range was 100° to 140°C.

The pressure in pressure transfer can be reduced somewhat even at temperatures below this, but this greatly increases developing time. This is because the action of the reaction accelerator contained in the photosensitive member 8 is impeded. A reaction accelerator with a small activation energy can be used to prevent this, but then the shelf life of the photosensitive member 8 is sacrificed.

In the high temperature range, however, the pressure used in pressure transfer can be lowered as the heating temperature is raised and the heating time for heat developing is shortened, but then the heat resistance of the photosensitive member 8 Presents a problem. This is because a thin PET film is generally used as the support member because of its low cost, wide applicability, heat conduction and other advantages. This film, however, is not highly resistant to heat and is difficult to handle. Further, when high temperatures are used, the materials, control, cost and other factors concerning the heating mechanism itself add further restrictions, and therefore the temperature cannot be made too high.

In this embodiment, the temperature conditions for heat developing and pressure transfer are nearly the same and basically cannot be changed, but if the characteristics of the photosensitive member 8 require it, the transport speed of the photosensitive member 8, the angle at which the photosensitive member 8 is wound around the upper pressure roller 61 or the diameter of the upper pressure roller 61 can be changed without changing the heating temperature, thus making it possible to achieve the necessary heating conditions for heat developing.

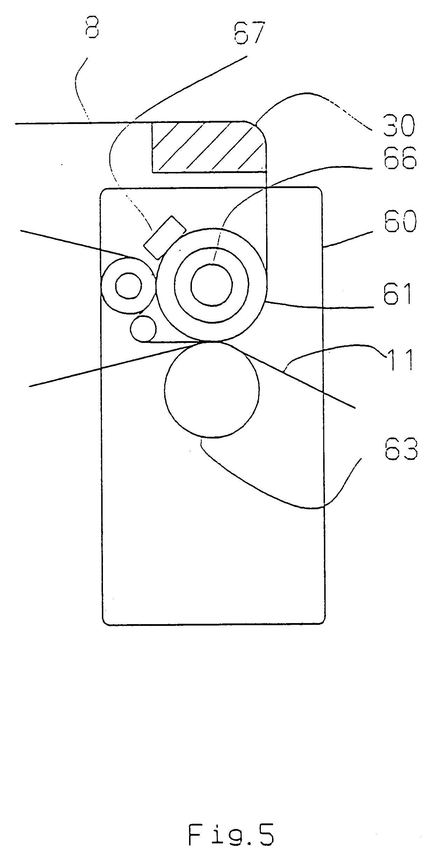

Fig. 5 is a front cross section of another embodiment of the heat developing device 30 and pressure transfer device 60. In this embodiment, the heating mechanism for heat developing and pressure transfer are independent.

The hollow upper pressure roller 61 in the Figure contains a halogen lamp heater 66 as the heat source. The heat developing device 30 is provided with another heater, not shown, in order to maintain its temperature nearly equal to that of the pressure transfer device 60, and since both are at the same temperature, they affect each other very little even when positioned close to each other as in this embodiment, thus making it possible to maintain a stable temperature over long periods. Further, since the photosensitive member 8 arrives at the pressure transfer device 60 immediately after undergoing heat developing in the heat developing device 30 and it undergoes heat transfer at nearly the same temperature, almost no thermal expansion or contraction occurs during this time, thus reducing the likelihood of the occurrence of wrinkles which cause uneven developing and poor transfer.

Instead of a halogen lamp heater, various types of heat sources can be used such as a ceramic heater, nichrome and other heating resistor elements.

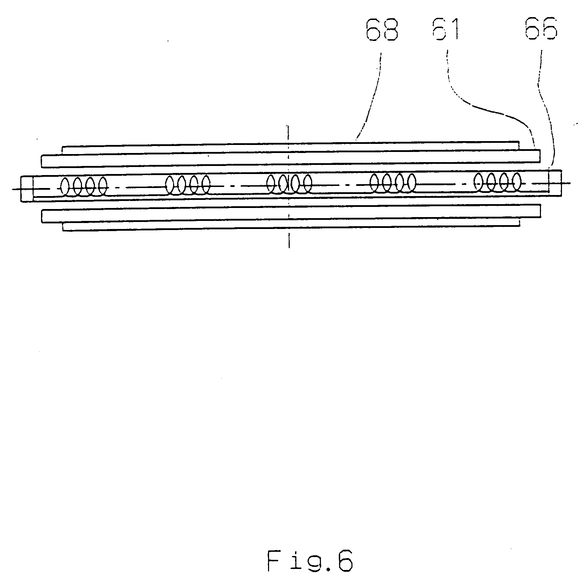

Fig. 6 is a developed cross section of the upper pressure roller 61 whose surface is covered with rubber 68, which is a plastic material. When the roller is hollow as in this embodiment, it is technologically difficult to improve the cylindricality of the roller, but by covering the surface of the roller with a material that is sufficiently soft compared to metal, such as rubber or plastic, shape defects can be absorbed by this material, thus making the pressure distribution in pressure transfer uniform and making it easier to suppress uneven density and wrinkles. When silicon rubber was coated in a thickness of 0.1 mm on the surface of the upper pressure roller 61 in this embodiment, a sharp image output was obtained.

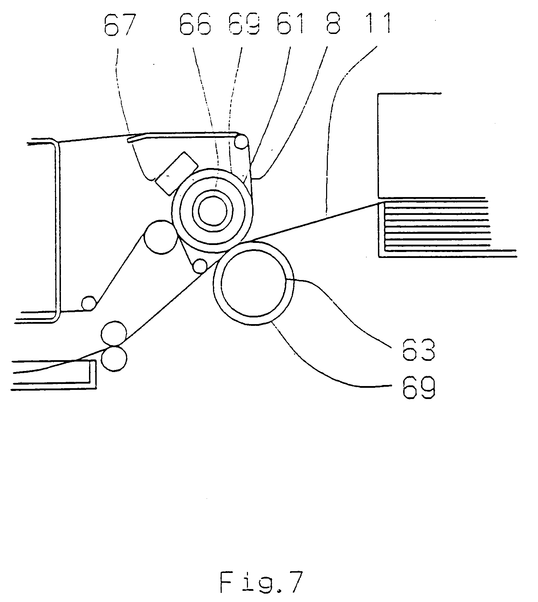

Fig. 7 shows an embodiment in which the surfaces of both the upper pressure roller 61 and the lower pressure roller 63 were coated with a urethane rubber 69. When the surface of only one of the rollers is coated with a rubber or plastic, slippage would sometimes occur between the transfer member 11 and the photosensitive member 8 during pressure transfer depending on the pressure conditions, resulting in a degraded image. In this embodiment, the surfaces of both the upper pressure roller 61 and the lower pressure roller 63 were covered with a 2 mm thick urethane rubber 69, the upper pressure roller 61 was controlled at 80°C, and the pressing force was 3000 N (300 kgf) for an A4 width, whereby good results were obtained. Further, since the lower pressure roller 63 was not supplied with a heat source, there was a concern as to whether the pressure transfer temperature would stabilize but the urethane rubber 69 covering the surface of the lower pressure roller 63 functioned as an insulator, and therefore consistent image quality was obtained by controlling only the temperature of the upper pressure roller 61.

In this embodiment silicon rubber and urethane rubber were used as the plastic material on the surface of the rollers, but of course the invention is not limited to these, and other rubber or plastic materials can be used as long as they have a certain amount of heat resistance and easily undergo plastic deformation. Further, since the pressure used is not sufficiently low in relatively low temperature ranges, the pressure rollers themselves must be made from an alloy or other material with sufficient rigidity, but in the higher temperature ranges, the pressure can be low, thus facilitating the use of rubber, plastic or other plastic materials for the entire pressure roller.

In the above explained embodiments of the invention , contact heating was used by the heating mechanism for both heat developing and pressure transfer, but the invention is not limited to this, and radiant heating, hot air heating, induction heating, resistance heating or any combination of these can be employed.

Also, instead of the fixed roller system described in this embodiment, pressure can be applied in the pressure transfer system by the reciprocating or circulating action of a small roller, and instead of a roller pressure system, impact or ultrasound vibration can be used.

Further, a copier was used here to explain the invention, but the invention is not limited to this, and it can be applied to printers, facsimile machines, electronic cameras and image forming devices in general.

As described above, the following effects can be achieved by means of the image forming device of the invention.

First, by using a configuration that uses the same heat source for heating in heat developing and heating in pressure transfer, a low cost, simple image forming device can be offered that is lighter and more compact.

Second, where heat developing and pressure transfer are performed at nearly the same temperature, the configuration is not only further simplified, a low cost image forming device can be offered that produces consistently high quality images.

Further, a more simplified configuration, improved image quality, higher reliability and lower cost can be achieved by using part of the roller of the pressure transfer device to perform heat developing.

Finally, by forming the surface of one or both of the rollers of the pressure transfer device with rubber, plastic or other plastic material, unevenness in both the temperature and pressure can be reduced, thus reducing uneven density appearing in the image and greatly improving image quality.

## Claims

1. An image forming device that uses a photosensitive member (8) with numerous microcapsules on in its surface, in which are enclosed at least a photosensitive material and a coloring material, and that performs heat developing by heating the image-exposed part of the photosensitive member, after which it transfers the image to a transfer member (11) by pressing the photosensitive member and transfer member together, wherein the heating for heat developing and the heating for pressure transfer are performed by the same heat source (32, 33, 66).

2. An image forming device according to claim 1, wherein the temperatures for heat developing and pressure transfer are substantially the same.

3. An image forming device that uses a photosensitive member (8) with microcapsules on a support member, in which are enclosed at least a photosensitive material and a coloring material, that performs heat developing by heating the photosensitive member after the photosensitive member has been exposed, and transfers the image to a transfer member (11) by pressing the photosensitive member and transfer member together, wherein heat developing and pressure transfer are performed at nearly the same temperature.

4. The image forming device of claim 1, 2 or 3, wherein heat developing and pressure transfer are performed by the same rollers (61, 63).

5. The image forming device of any of the preceding claims, wherein the surface of at least one of the rollers (61) used for pressure transfer and heat developing is formed from a plastic material (68).

20 21 65 8 5 6 4 3 7 30 2 1

A

64
13
14
10

16
61
62
60
11
15
12

63

Fig.1

EP 0 483 805 A1

7

Fig.2

Fig.3

Fig.4

Fig.5

68    61    66

Fig.6

67　　66 69 61　8　11

63

69

Fig.7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | US-A-4 942 420 (TOMIZAWA ET AL.) <br> * column 1, line 7 - line 11 * <br> * column 5, line 54 - line 65; figures 1,2 * <br> --- | 1-5 | G03B27/32 <br> G03F7/00 |
| D,Y | US-A-4 799 085 (NAGUMO ET AL.) <br> * column 1, line 6 - line 15 * <br> * column 3, line 10 - column 5, line 10; figures 1,2 * <br> --- | 1-5 | |
| A | US-A-4 841 339 (TANIGUCHI) <br> * abstract * <br> * column 2, line 7 - line 61; figure 1 * <br> ----- | 1,3 | |
| | | | TECHNICAL FIELDS SEARCHED (Int. Cl.5 ) |
| | | | G03B <br> G03F <br> G03G |

The present search report has been drawn up for all claims

| Place of search | Date of completion of the search | Examiner |
|---|---|---|
| THE HAGUE | 09 MARCH 1992 | GREISER N. |

EPO FORM 1503 03.82 (P0401)